# EUROPEAN PATENT SPECIFICATION

(11) **EP 4 372 134 B1**
(45) Date of publication and mention of the grant of the patent: **01.07.2026**
(21) Application number: 22208476.6
(22) Date of filing: 21.11.2022
(51) Int. Cl.: D03D 1/00, D03D 15/283, D03D 15/292, D03D 15/567, D03D 15/41, H02G 15/18, H05K 9/00

(54) **HEAT-SHRINK FABRIC TUBING AND METHOD OF CONSTRUCTING A HEAT-SHRINK FABRIC TUBING**
WÄRMESCHRUMPFBARER GEWEBESCHLAUCH UND VERFAHREN ZUR HERSTELLUNG EINES WÄRMESCHRUMPFBAREN GEWEBESCHLAUCHS
TUBE EN TISSU THERMORETRACTABLE ET PROCEDE DE CONSTRUCTION D'UN TUBE EN TISSU THERMORETRACTABLE

(43) Date of publication of application: 22.05.2024
(73) Proprietor: Tyco Electronics UK Ltd, Wiltshire SN3 5HH (GB)
(72) Inventor: KURUP, Sreeni, Swindon, SN3 5HH GB (GB); SCOTT, Paul, Swindon, SN3 5HH GB (GB); SHEPHERD, Celine, Swindon, SN3 5HH GB (GB)
(74) Representative: Grünecker Patent- und Rechtsanwälte PartG mbB

(56) References cited:
- DE-T2- 69 222 865
- KR-A- 20160 053 219
- US-A- 4 668 545
- US-A1- 2018 287 357

## Description

The invention relates to a heat-shrink fabric tubing for shielding an elongated component against electromagnetic interference (EMI) and a method of constructing such a heat-shrink fabric tubing.

A heat-shrink fabric tubing (or, commonly, heat shrink, heatshrink, heat recoverable tube, or shape memory tube) is a shrinkable fabric polymeric tube used on for example on elongated components, such as wires, to insulate and/or provide abrasion resistance and environmental protection. Heat-shrink fabric tubing is ordinarily made of a material, which shrinks radially (with negligible longitudinal shrinkage), i.e. in travers to the longitudinal extension of the elongated component, when heated.

Recently, electric vehicles (EV) have become of more importance. An EV is a vehicle that uses one or more electric motors for propulsion. A storage, such as a battery or hydrogen tank, can be used to store the energy used to power the EV. For connecting the battery and the motor, usually busbars are used.

In electric power distribution, Original Equipment Manufacturers (OEMs) are now considering busbars instead of cables for carrying higher current for fast charging applications. A busbar (also referred to as bus bar) is a metallic strip or bar, typically housed inside an appliance, e.g. the EV, for local high current power distribution.

Notably, high current power distribution is not limited to EVs but may be subject to other applications as well, such as connectors, cables, charging stages or the like in the automotive, aerospace, and other industries.

The high current power distribution by a busbar, a wire, or the like causes electromagnetic interference (EMI), also called radio-frequency interference (RFI) when in the radio frequency spectrum. EMI is a disturbance generated by a source that affects an electrical circuit by electromagnetic induction, electrostatic coupling, or conduction. With increasing electrical and electronic content in confined spaces being a key trend across industries, electrical interference solutions for protection from both internal and external EMI sources is becoming more critical. The disturbance caused by may degrade the performance of the circuit or even stop it from functioning with potentially serious consequences. In the case of a data path, these effects can range from an increase in error rate to a total loss of the data.

For example in the case of an EV, the busbars need to distribute the high currents to power the motor. At the same time, the busbars need to be shielded so that the circuits in the EV are not disturbed by the current distributing busbars.

It is known to shield elongated components such as wires and busbars against EMI by disposing a protective textile sleeve and a separate outer abrasion resistant tube about the wires. Upon disposing the textile sleeve about the wires and then the abrasion resistant tube about the textile sleeve, the abrasion resistant tube can be heat-shrunk about the textile sleeve. Accordingly, the inner textile sleeve provides the EMI protection, while the heat-shrunk tube provides protection against abrasion. Although such textile sleeves and tubes can prove effective in shielding against EMI and providing protection against abrasion, they are costly from both a material and labor standpoint, having to essentially assembly two separate sleeves about the member being protected.

Alternatively, it is known to shield wires against EMI by using a textile sleeve for protecting elongate members against EMI. The sleeve includes a wall having opposite edges extending lengthwise in generally parallel relation with a longitudinal axis between opposite ends. In other words, the sleeve is a fabric that does not form a closed tube. Rather, opposite edges of the fabric are configured to overlap one another to bind a central cavity extending between the opposite ends. The wall includes warp filaments, extending generally parallel to the longitudinal axis, woven with weft filaments, extending generally transversely to the warp filaments. The warp filaments include substantially electrically non-conductive filaments woven in a plain weave pattern with the weft filaments and electrically conductive members woven with the weft filaments to form a plurality of floats, with each of the floats extending over at least two adjacent ones of the weft filaments. Although such a textile sleeve can prove effective in shielding against EMI, the sleeve may not tightly fit to the complex geometries of busbars, which can have a rectangular cross section. In particular, by wrapping, the sleeve around a busbar and overlapping the edges is from an installation perspective difficult and air traps can occur between the sleeve and the busbar.

In view of the above, for shielding an elongated component against EMI, a solution is needed that can fit tightly to the elongated component. Further, solution needs to be easy to handle, flexible, and lightweight. Further, the solution shall be adapted to retrofit easily and no additional materials (e.g. taping) should be required. Further, the solution should be adjustable in view of the EMI shielding performance and economical to fabricate.

US 2018/0287357 A1 relates to a woven sleeve.

DE 692 22 865 T2 relates to a heat-recoverable material.

KR 2016 0053219 A relates to heat shrinkable fabric sleeve. US 4 668 545 A discloses a heat-shrink fabric tubing and a method according to the preamble of the independent claims.

At least one of objects discussed above is solved by the independent claims. Advantageous embodiments are solved by the dependent claims. Examples mentioned in the following description that are not necessarily falling under the scope of the independent claims are useful for understanding the invention.

Recently, the inventors found out that weft fiber for shrinking a heat shrink tube can be woven in combination with electrically conductive yarns, namely polyamide fiber coated with a metal for producing a heat-shrinkable (also referred to as heat recoverable) conductive fabric tube for EMI protection.

According to the invention, a fabric for a heat-shrink fabric tubing comprises warp fibers, extending in a longitudinal extension of the elongated component. The warp fibers are woven with weft fibers. The weft fibers are cross-linked for creating a memory in the tube so that the fabric tubing shrinks after applying heat and the warp fibers are electrically conducting for EMI shielding the elongated component.

Thus, a heat recoverable fabric article (namely a tube) is generated that shrinks with the application of heat and fits tightly and securely around the underlying substrate. In particular, heat shrink is the ability of the material to recover to its original shape from its temporary state. Thus, this tube is easy to handle, because only the article, namely the tube, has to be mounted to the elongated component. Further, by shrinking the tube, the tube tightly fits to the elongated component, i.e. by shrinking, a tight fit is ensured. Finally, heat-shrink tubes are particularly easy to handle and good for retrofitting.

Notably, the heat-shrink fabric tubing does not use for the weft fibers a heat settable monofilament polyethylene terephthalate (PET) polymer, which is different from the cross-linked weft fibers that are heat recoverable. In particular, heat setting is a term used in the textile industry to describe a thermal process. The effect of this thermosetting process gives fibers dimensional stability, however, heat setting does not create a memory in the fibers for shrinking the weft fibers after applying heat.

According to the invention, a heat-shrink fabric tubing for shielding an elongated component against electromagnetic interference (EMI) comprises electrical conducting warp fibers, the warp fibers comprise a non-conductive polyamide, plated with a conductive metal layer, the warp fibers for EMI shielding of the elongated component, the warp fibers extending in a longitudinal extension of the elongated component.

The inventors have identified that metal plated polyamide fibres can be woven with cross-linked polyolefin fibres to produce a lightweight and flexible fabric tube for EMI shielding.

Previously, a heatshrink wrap around tube was fabricated using other fiber materials. For example, conductive warp fibers were fabricated using materials such as metals or polymer loaded with carbon black. Such materials, however, do not require a coating as the core itself is conducting. Further, non-conductive cores, such as glass, were used and plated with a metal. Glass, however, is not as flexible and lightweight as a non-conductive polymer. Notably, conductive polymer, i.e. a polymer loaded with carbon black is brittle compared to a non-conductive polymer. Advantageously, the warp fibers comprise multifilament yarn for EMI shielding of the elongated component, the warp fibers extending in a longitudinal extension of the elongated component.

Choosing multifilament yarns enable to tune at least the EMI shielding efficiency. For example, by changing the level of conductivity a filament of the multifilament yarn, the EMI shielding of the heat-shrink fabric tubing can be tuned for a specific application, e.g. for the application of carrying current by a busbar.

Further, the heat-shrink fabric tubing according to the invention comprises shrinkable weft fibers extending transversely to the electrical conducting warp fibers, the weft fibers for shrinking the fabric tubing in a radial dimension perpendicular to the longitudinal extension by applying heat. Additionally, the weft fibers are woven with the warp fibers thereby forming the fabric tubing protecting the elongated component against EMI.

As used herein, warp and weft are the two basic components used in weaving to turn fibers, filaments or yarn into fabric, here the shape of the tube. For example, the lengthwise or longitudinal warp fibers, i.e. the warp fibers extending the longitudinal extension of the elongated component, are held stationary in tension for example on a frame or loom while the transverse weft is drawn through and inserted over and under the warp. This enables to generate a tubular fabric that is easy to install, in particular on a busbar.

As used herein, a tube is a collapsible package, which is used for containing the elongated component. For example, a tube is a cylindrical, hollow piece with a round opening, the tube is made of by the woven fabric. In particular, both ends of the heat shrink tube can be round openings. However, depending on the application and shielding requirement, it may be preferable to only have one end of the tube open. Thus, a tubular shape enables easy and fast installation, i.e. a time saving installation, which is of importance for the user, in particular in the field electrical harness protection in the automotive (e.g. EVs) aerospace, military and other markets.

Further, the weft fibers are cross-linked for creating a memory in the tube so that the fabric tubing shrinks after applying heat.

As used herein, cross-linking is a bond or a short sequence of bonds that links one polymer chain to another. These links may take the form for example of covalent bonds or ionic bonds and the polymers can be synthetic polymers.

In particular, a process of fabricating a heat-shrinkable tube comprises extruding a starting tube. The tube is taken to a separate process where it is cross-linked, for example through radiation. The cross-linking creates a memory in the tube. Then, the tube is heated to just above the polymer's crystalline melting point and expanded in diameter, often by placing it in a vacuum chamber. While the tube is in the expanded state, it is rapidly cooled. In other words, the tube keeps its expanded state when cooling.

When a customer receives the expanded fabric tubing product for an EMI shielding application, the fabric tube can be applied to the selected substrate and when heated again (above the crystalline melting point of the material) by the end user, the fabric tubing shrinks back and recovers to its original non-expanded size.

In particular, the cross-linked weft fibers enable that the end user can fit the heat shrink fabric tubing tightly and securely around the underlying substrate by applying heat. Further, the heat shrink ability provides the flexibility to fit on complex geometries, e.g. a stripe like geometry of a busbar.

Thus, the invention enables the construction of a heat recoverable fabric article for EMI shielding of wires, cables, busbars, connectors, and electronic components from both external and internal electromagnetic radiation.

As used herein, plating is a surface covering in which a metal is deposited on a surface. Plating enables to alter the conductivity, and thus, tune the radiation shielding. Thus, a shielding effectiveness for a specific application can be selected. Additionally, the use of polymer plated warp fibers has the advantage of a flexible, lightweight fabric tubing.

According to an embodiment, at least an individual filament of the multifilament warp fiber is plated with the metal.

According to an embodiment, at least a warp fiber is plated with the metal. Plating the individual fibers and/or the warp fiber enables to alter the conductivity, and thus, tune the radiation shielding effectiveness.

According to an embodiment, the metal comprises silver, copper, nickel, or tin. Advantageously, the metal comprises silver having a purity of equal or more than 99.9 %.

The electrical resistance of silver is lower compared to other metals, in particular compared to copper; more so at higher frequencies due to the skin effect. Thus, silver plating enables high EMI shielding.

Using copper, nickel, or tin is advantageous as it provides an economic solution. All mentioned metals allow tuning the EMI shielding of the tube..

According to an embodiment, the electrical conductive warp fibers have an electrical resistance of equal or more than 1 ohms/meter and/or an electrical resistance of equal or less than 50 ohms/meter.

As used herein, the electrical resistance is defined in the fabrication of yarns as ohms/meter, i.e. the change of resistance per meter. Alternatively, the electrical resistivity of an object can be defined; the electrical resistivity is a measure of its opposition to the flow of electric current and depends on the material the fiber is made, the material the fiber is plated with, the size and the shape of the fiber, and thickness of the plating. For example, a wire's resistivity is higher if it is long and thin, and lower if it is short and thick.

According to an embodiment, the plated warp fibers have a linear density of equal to or greater than 1000 dtex a linear density of equal to or less than 1500 dtex, preferably the plated warp fibers have a linear density of equal to or greater than 1200 dtex a linear density of equal to or less than 1250 dtex. Dtex (deci-tex) is grams per 10,000 meters of yarn.

According to an embodiment, the non-conductive polyamide core has a linear density of equal to or greater than 200 dtex and a linear density of equal to or less than 300 dtex, preferably the non-conductive polyamide core has a linear density of equal to or greater than 230 dtex and a linear density of equal to or less than 250 dtex.

According to the invention, the fabric tubing comprises before shrinking equal to or greater than 10 warp fibers per cm and equal to or less than 50 warp fibers per cm in a circumferential dimension perpendicular to the radial dimension, and wherein the fabric tubing comprises before shrinking equal to or greater than 3 weft fibers per cm and equal to or less than 10 weft fibers per cm in the longitudinal extension.

According to an embodiment, the plated warp fibers have a twist of equal to or greater than 350 turns per meter and a twist of equal to or less than 400 turns per meter, preferably wherein the plated warp fibers are spun with a Z twist.

The yarn twist is a parameter used for describing a fabric tubing. The amount of twist required to hold the fibers and yarns together depends on the diameter and size of yarns, which has been described above by the dtex values. The coarse yarn needs less amount of twist to hold the fibers together in the yarn and fine yarn needs more amount of twist to hold the fibers together in the yarn. The amount of twist or degree of twist seriously affects the performance of yarn. If the yarn has less twist than standard then fiber slippage may occur. The yarn having low twist posses low strength. There may be the chance of pilling formation due to low twist. It will give soft feel and touch. If the yarn has more twist than standard. The yarn will show good strength but it will give rough feel and touch. There may be a chance of snarling too. The amount of twist is expressed in turns/meter. The anticlockwise twist of yarn is called z-twist. The inclination of fibers in the yarn looks similar to the middle part of English letter Z.

According to an embodiment, the plated warp fibers have a tenacity of equal to or greater than 35 cN/tex and/or tenacity of equal to or less than 60 cN/tex [centi Newton/ tex], preferably the plated warp fibers have a tenacity of equal to or greater than 40 cN/tex and/or a tenacity of equal to or less than 55 cN/tex, and/or wherein the plated warp fibers have an elongation up to break of equal to or greater than 10 % and an elongation up to break of equal to or less than 40 %, preferably the plated warp fibers have an elongation up to break of equal to or greater than 20 % and an elongation up to break of equal to or less than 32 %.

By the selection of the warp fibers linear density, the number of filaments, the twist, the tenacity, and elongation up to break, the shielding efficiency and the flexibility of the heat-shrink fabric tubing can be tuned.

According to the invention, the warp fibers comprise nylon 66 or nylon 6. Thus, the warp fiber has a high mechanical strength, rigidity, good stability under heat and/or chemical resistance.

Nylon 66 is made of two monomers each containing 6 carbon atoms, hexamethylenediamine and adipic acid, which give nylon 66 its name. Nylon 66 has the International Union of Pure and Applied Chemistry (IUPAC) name Poly[imino(1,6-dioxohexamethylene) iminohexamethylene]. Nylon 6, also know as polycaprolactam, having the IUPAC name Poly(azepan-2-one); poly(hexano-6-lactam), is a polymer with the properties of nylon 66.

According to an embodiment, the length of the cross-linked weft fibers in an expanded state before shrinking is equal to or more than 1.5 times the length of the weft fibers after shrinking.

According to an embodiment, the length of cross-linked weft fibers in an expanded state before shrinking is equal to or less than 4 times the length of the weft fibers after shrinking. A higher expansion ratio is favorable, in particular it is easier for the customer to handle such a tube. Changing the ratio helps to make the product tailored for the substrate and manufacturing processes.

According to an embodiment, the weft fibers comprise polyolefin, polyolefin based copolymers, nylons and fluoropolymers.

According to an embodiment, the weft fibers are radiation cross-linked or peroxide cross-linked.

According to an embodiment, the electrically conducing warp fibers comprise an outermost layer of an insulating material. Thus, the elongated component can be provided with an insulating shielding, and thus, can insulate the elongated component. Further, this layer enables an abrasion resistance which is particular important to protect the metal layer. Preferably, the shielding comprises nitrile rubber.

According to an embodiment, the fabric tubing comprises a seam extending in the longitudinal extension of the elongated component, preferably the fabric tubing comprises only one seam extending in the longitudinal extension of the elongated component, optionally an interlocking yarn is woven into fabric tubing, the interlocking yarn forming the seam. According to one solution two woven sheets, woven together with two seams (two interlocking stitch yarns). Such a solution requires multiple steps to fabricate the product and the final fabric-tubing product has two weak points, the two seams.

A circular weaving pattern is challenging to weave small tubes.

A single seam (one interlocking stitch yarn) - is advantageous as there is only one main seam (so one weak point) and it can be manufactured in a single step and small diameters can be fabricated.

According to the invention, a method of constructing a heat-shrink fabric tubing for shielding an elongated component against EMI is described. The method comprises the steps of: weaving electrical conducting warp fibers, at least one warp fiber comprising a non-conductive polyamide core plated with a conductive metal layer, the warp fiber for EMI shielding of the elongated component, with heat shrinkable weft fibers, wherein the warp fibers extending in a longitudinal extension of the fabric tubing and the weft fibers extending transversely to the warp fibers thereby forming the heat-shrink fabric tubing; and wherein the non-conductive core of the warp fibers comprises nylon 66 or nylon 6, wherein the fabric tubing comprises before shrinking equal to or greater than 10 warp fibers per cm and equal to or less than 50 warp fibers per cm in a circumferential dimension perpendicular to the radial dimension, and equal to or greater than 3 weft fibers per cm and equal to or less than 10 weft fibers per cm in the longitudinal extension, and cross-linking the heat shrinkable weft fiber.

The components discussed in the method can be modified in line with the description of any of the embodiments described above.

The invention will now be described in detail and in an exemplary manner using advantageous embodiments and with reference to the drawings. The described embodiments are only possible configurations in which, however, the individual features as described above can be provided independently of one another or can be omitted within the scope of the independent claims.

The accompanying drawings are incorporated into the specification and form a part of the specification to illustrate several embodiments of the present invention. These drawings, together with the description serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form-individually or in different combinations-solutions according to the present invention. The following described embodiments thus can be considered either alone or in an arbitrary combination thereof. The described embodiments are merely possible configurations and it must be borne in mind that the individual features as described above can be provided independently of one another or can be omitted altogether while implementing this invention according to the independent claims. Further features and advantages will become apparent from the following more particular description of the various embodiments of the invention, as illustrated in the accompanying drawings, in which like references refer to like elements, and wherein:
- **FIG. 1**: is a schematic of a heat-shrink fabric tubing according to an example;
- **FIG. 2**: is a diagram showing a measured shielding effectiveness according to an example;
- **FIG. 3**: is a block diagram of a first method for producing a heat-shrink fabric tubing; and
- **FIG. 4**: is a block diagram of a second method for producing a heat-shrink fabric tubing.

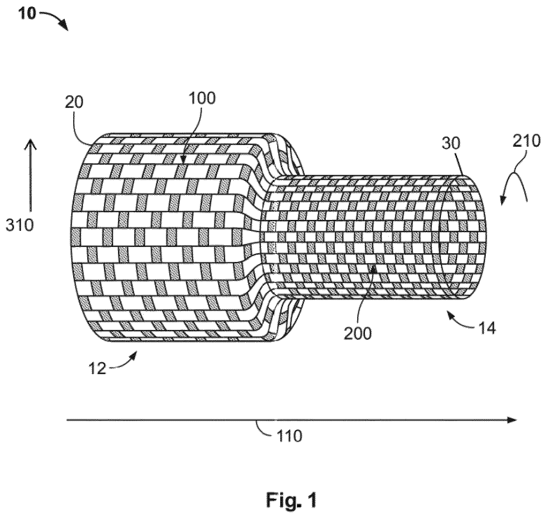

The present invention will now be described with reference to the drawings. Fig. 1 shows a schematic of a heat-shrink fabric tubing 10 for shielding an elongated component (not shown) against electromagnetic interference (EMI) according to an example.

The heat-shrink fabric tubing 10 forms a hollow body with a cylindrical surface. The hollow body has a first opening 20 and a second opening 30, which according both have a circular shape. The first opening 20 and the second opening 30 extend in a radial dimension, indicated in Fig. 1 by radial axis 310, the radial axis being perpendicular to a longitudinal dimension, indicated in Fig. 1 by longitudinal axis 110. The edge of the first opening 20 and the second opening 30 defining a circumferential dimension indicated by the circumferential axis 210.

Further, the heat-shrink fabric tubing 10 of Fig. 1 comprises an expanded portion 12 and a non-expanded portion 14. The expanded portion 12 shows a heat-shrink fabric tubing as for example sold to a user. The non-expanded porition14 has a smaller diameter than the expanded portion 12 in the radial dimension.

Further, the heat-shrink fabric tubing comprises a plurality of electrical conducting warp fibers 100. The warp fibers comprise for example multifilament yarn for EMI shielding of the elongated component.

The warp fibers 100 extend in a longitudinal extension of the not shown elongated component. In other words, the warp fibers 100 extend along the longitudinal axis 110. Notably, the warp fibers do not substantially shrink upon application of heat, i.e. the shrinkage is less than 20% along the longitudinal axis 110. Thus, the elongated component can shielded completely in the dimension of the longitudinal axis 110.

Further, the heat-shrink fabric tubing comprises a plurality of shrinkable weft fibers 200 extending transversely to the electrical conducting warp fibers, the weft fibers for shrinking the fabric tubing in the direction of the radial axis 310. In other words, the weft fibers follow the circumferential dimension 210. In particular, the weft fibers 200 follow in the expanded state the shape of the first opening 20 and the weft fibers 200 follow in the non-expanded sate the shape of the second opening 30.

As shown in Fig. 1, the weft fibers 200 are woven with the warp fibers 100 thereby forming the fabric tubing for protecting the elongated component against abrasion. In more detail, the woven fabric is a fabric consisting of two thread systems, warp and weft, which usually cross each other in a pattern at an angle of exactly or approximately 90° when viewed from the fabric surface. The warp fibers 100, also referred to as warp threads, run in the longitudinal direction of the fabric, i.e. parallel to the longitudinal axis 110, and the weft fiber 200, also referred to as weft threads, run in the transverse direction, parallel to the fabric edge, i.e. to the openings 20 and 30, i.e. the circumferential axis 210. The weft fibers 200 and warp fibers 100 can be joined to the fabric for example mainly by frictional contact. For a fabric to be sufficiently resistant to shearing, the warp fibers 100 and weft fibers 200 usually have to be woven so that abutting weft fibers and abutting warp fibers are in contact. In other words, the fabrics may have a closed fabric appearance.

According to an example, the plated warp fibers have a linear density of equal to or greater than 1000 dtex a linear density of equal to or less than 1500 dtex, preferably the plated warp fibers have a linear density of equal to or greater than 1200 dtex a linear density of equal to or less than 1250 dtex.

According to the invention, the fabric tubing comprises before shrinking equal to or greater than 10 warp fibers per cm and equal to or less than 50 warp fibers per cm in a circumferential dimension perpendicular to the radial dimension, and the fabric tubing comprises before shrinking equal to or greater than 3 weft fibers per cm and equal to or less than 10 weft fibers per cm in the longitudinal extension.

According to a further example, the plated warp fibers have a twist of equal to or greater than 350 turns per meter and a twist of equal to or less than 400 turns per meter, preferably wherein the plated warp fibers are spun with a Z twist.

Further, as shown in Fig. 1, the weft fibers are cross-linked for creating a memory in the tube so that the fabric tubing shrinks after applying heat. For example, the heat-shrink fabric tube is woven in the non-expanded state 14. In this state, the weft fibers are cross-linked. Then, the tube is expanded to the expanded state 12.

Alternatively, the weft fibers are stretched. Then, the heat-shrink fabric tube is woven in the expanded state 12. In this state, the weft fibers are cross linked. Thus, the tube can receive in the expanded state 12 an elongated component.

Further, upon application of heat by the user, the fabric tube recovers to the non-expanded state 14. Notably, with an elongated component received in the fabric tube, the tube will mainly follow the shape of the elongated component, for example the rectangular shape of a busbar.

For example, a fabric tube having an inside diameter of 35 mm may form a recovered fabric tube with inside diameter of 10 mm. In other words, the length of cross-linked weft fibers 200 in an expanded state before shrinking is equal to 3.5 times the length of the weft fibers 200 after shrinking.

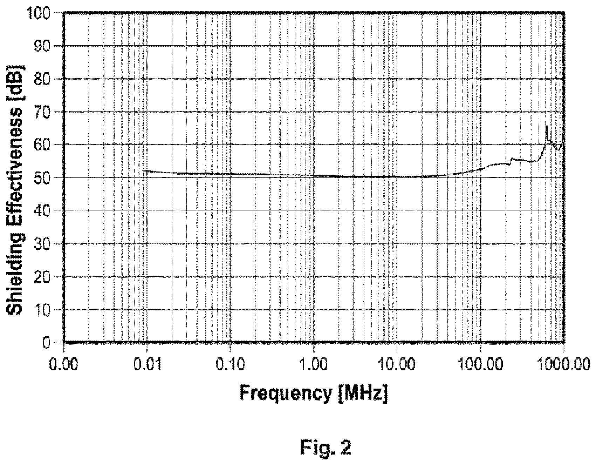

Further, Fig. 2 shows a measured shielding effectiveness. For example, a heat recoverable fabric tube constructed using silver plated multifilament polyamide warp fibers 100 and crosslinked polyethylene weft fibers 200 has a shielding effectiveness of more than 40 dB in the frequency range from 10Kz to 1GHz in the recovered form, preferably recovered by more than 50%.

In the example, the fabric comprises multifilament conductive warp fibres 100, in particular polyamide (Nylon 6.6) warp fibres plated using 99.9% pure silver with electrical resistivity of 40 ohms/meter. The heat recoverable weft fiber 200 used in the example comprise a radiation crosslinked polyolefin (polyethylene) fiber.

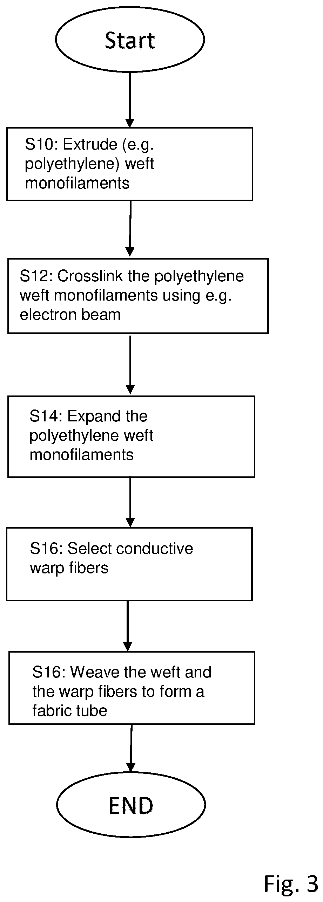

Fig. 3 is a schematic of a method for producing a heat-shrink fabric tubing for shielding an elongated component against EMI.

The method comprises a step of extrude weft fibers, for example polyethylene is extruded and for example the weft fibers are monofilaments (Step S10).

Further, the process comprises crosslink the weft fibers (Step 12). The weft fibers may be cross-linked by radiation, such as an electron beam. Thus, the weft fibers memorize the shape of the non-expanded state.

Further, the process comprises expand the cross-linked weft fibers (Step 14).

Further, the process comprises selecting conductive warp fibers (Step 16).

The fibers have been described in particular with reference to above Figs. 1 and 2. In particular, a metal plated core, the core comprising a polyamide, forms at least one warp fiber. Thus, the warp fiber enable for EMI shielding of the elongated component. Further, the heat-shrink fabric tubing comprises heat shrinkable weft fibers, wherein the warp fibers extending in a longitudinal extension of the fabric tubing and the weft fibers extending transversely to the warp fibers. For example, the non-expanded portion 14 in Fig. 1 forms such a starting tube. Then, the process comprises weaving the weft and warp fibers to form a fabric tubing (Step 18). Notably, even if not shown in above Fig. 1, the fabric tubing can comprise a seam, in particular only one seam along the longitudinal axis. For example, the longitudinal seam comprises an interlocking stitch yarn, which is different from the weft and warp fibers. For example, the interlocking stitch yarn is a non-conductive or a conductive yarn. This solution is advantageous as there is only one main seam necessary (so only one weak point) and the tube can be manufacturing in a single step and small diameters can be fabricated.

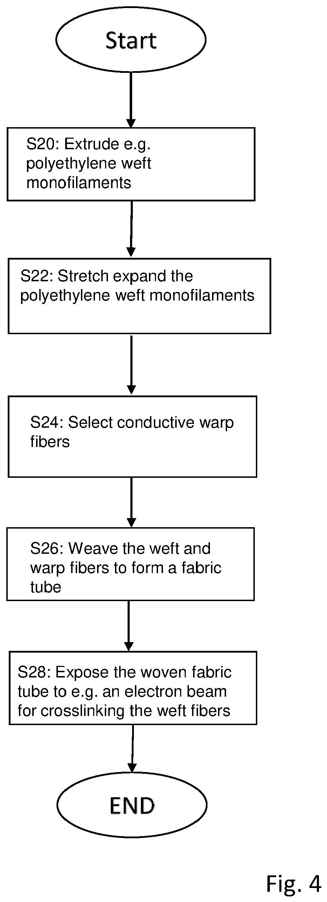

Fig. 4 is a schematic of an alternative method for producing a heat-shrink fabric tubing for shielding an elongated component against EMI.

The method comprises a step of extrude weft fibers, for example polyethylene is extruded and for example the weft fibers are monofilaments (Step S20).

Further, the process comprises expand the weft fibers (Step 22).

Further, the process comprises selecting conductive warp fibers (Step 24).

The fibers have been described in particular with reference to above Figs. 1 and 2. In particular, a metal plated core, the core comprising a polyamide, forms at least one warp fiber. Thus, the warp fiber enables for EMI shielding of the elongated component. Further, the heat-shrink fabric tubing comprises heat shrinkable weft fibers, wherein the warp fibers extending in a longitudinal extension of the fabric tubing and the weft fibers extending transversely to the warp fibers. For example, the non-expanded portion 14 in Fig. 1 forms such a starting tube. Then, the process comprises weaving the weft and warp fibers to form a fabric (Step S26). For example, the process step may comprise weaving the fabric tubing, which comprises a seam described above with reference to step S18.

Further, the process comprises crosslink the fabric (Step 28). The weft fibers may be cross-linked by radiation, such as an electron beam. Thus, the weft fibers memorize the shape of the non-expanded state.

Notably, above Fig. 1 shows a tube with a circular cross section. Alternative the tube may have in the expanded and non-expanded state a different cross section, for example the tube may follow in the circumferential dimension of a polygonal shape. Further, Fig. 1 shows a tube with two openings. The heat-shrink fabric tubing may be also a tube with only one opening, i.e. a pocket, or may have more than two openings.

### REFERENCE NUMERALS

| **Reference Numeral** | **Description** |
|---|---|
| 10 | heat-shrink fabric tubing |
| 12 | expanded portion |
| 14 | recovered portion, non-expanded portion |
| 20 | first opening |
| 30 | second opening |
| 100 | warp fibers |
| 110 | longitudinal axis |
| 200 | weft fibers |
| 210 | circumferential axis |
| 310 | radial axis |

## Claims

1. A heat-shrink fabric tubing (10) for shielding an elongated component against electromagnetic interference, EMI, the heat-shrink fabric tubing comprising:
electrically conducting warp fibers (100), the warp fibers for EMI shielding of the elongated component, the warp fibers extending in a longitudinal extension of the elongated component;
shrinkable weft fibers (200) extending transversely to the electrically conducting warp fibers, the weft fibers for shrinking the fabric tubing in a radial dimension perpendicular to the longitudinal extension;
wherein the weft fibers are woven with the warp fibers thereby forming the fabric tubing for protecting the elongated component against EMI, and
the weft fibers are cross-linked for creating a memory in the tube so that the fabric tubing shrinks circumferentially after applying heat, and
wherein the fabric tubing comprises before shrinking equal to or greater than 10 warp fibers per cm and equal to or less than 50 warp fibers per cm in a circumferential dimension perpendicular to the radial dimension, and equal to or greater than 3 weft fibers per cm and equal to or less than 10 weft fibers per cm in the longitudinal extension,
**characterised in that** the warp fibers comprise a non-conductive polyamide core plated with a conductive metal layer and **in that** the non-conductive core of the warp fibers comprises nylon 66 or nylon 6.

2. Heat-shrink fabric tubing according to claim 1, wherein each warp fiber is formed as a multifilament yarn, each individual filament of the multifilament yarn is plated with conductive metal layer.

3. Heat-shrink fabric tubing according to any of claims 1 to 2, wherein the metal comprises silver, copper, nickel, or tin, preferably the metal comprises silver having a purity of equal to or more than 99.9 %.

4. Heat-shrink fabric tubing according to any of the preceding claims, wherein the warp fibers have an electrical resistance of equal to or more than 1 milli ohms*meter and/or an electrical resistivity of equal to or less than 50 ohms/meter.

5. Heat-shrink fabric tubing according to any of the preceding claims, wherein the plated warp fibers have a linear density of equal to or greater than 1000 dtex, and equal to or less than 1500 dtex, preferably equal to or greater than 1200 dtex and equal to or less than 1250 dtex.

6. Heat-shrink fabric tubing according to any of the preceding claims, wherein the non-conductive polyamide core has a linear density of equal to or greater than 200 dtex and equal to or less than 300 dtex, preferably the non-conductive polyamide core has a linear density of equal to or greater than 230 dtex and equal to or less than 250 dtex.

7. Heat-shrink fabric tubing according to any of the preceding claims, wherein the plated warp fibers have a twist of equal to or greater than 350 turns per meter and a twist of equal to or less than 400 turns per meter, preferably wherein the plated warp fibers are spun with a Z twist.

8. Heat-shrink fabric tubing according to any of the preceding claims, wherein the crosslinkable weft fibers comprise at least one of a polyolefin, polyolefin based copolymers, nylons and fluoropolymers.

9. Heat-shrink fabric tubing according to any of the preceding claims, wherein the length of cross-linked weft fibers in an expanded state (12) before shrinking is equal to or more than 1.5 times the length of the weft fibers after shrinking, and/or wherein the length of cross-linked weft fibers in an expanded state (12) before shrinking is equal to or less than 4 times the length of the weft fibers after shrinking.

10. Heat-shrink fabric tubing according to any of the preceding claims, wherein the electrically conducting warp fibers comprise an outermost layer of an insulating material, preferably comprising nitrile rubber.

11. Heat-shrink fabric tubing according to any of the preceding claims, wherein the plated warp fibers have a tenacity of equal to or greater than 35 cN/tex and/or tenacity of equal to or less than 60 cN/tex, preferably the plated warp fibers have a tenacity of equal to or greater than 40 cN/tex and/or a tenacity of equal to or less than 55 cN/tex, and/or wherein the plated warp fibers have an elongation up to break of equal to or greater than 10 % and an elongation up to break of equal to or less than 40 %, preferably the plated warp fibers have an elongation up to break of equal to or greater than 20 % and an elongation up to break of equal to or less than 32 %.

12. Heat-shrink fabric tubing according to any of the preceding claims, wherein the fabric tubing comprises a seam extending in the longitudinal extension of the elongated component, preferably the fabric tubing comprises only one seam extending in the longitudinal extension of the elongated component, optionally an interlocking yarn is woven into fabric tubing, the interlocking yarn forming the seam.

13. A method of constructing a heat-shrink fabric tubing for shielding an elongated component against EMI, the method comprising:
weaving (S10) electrically conducting warp fibers (100), the warp fiber for EMI shielding of the elongated component, with heat shrinkable weft fibers (200), wherein the warp fibers extending in a longitudinal extension of the fabric tubing and the weft fibers extending transversely to the warp fibers thereby forming the heat-shrink fabric tubing;
wherein the fabric tubing comprises before shrinking equal to or greater than 10 warp fibers per cm and equal to or less than 50 warp fibers per cm in a circumferential dimension perpendicular to the radial dimension, and equal to or greater than 3 weft fibers per cm and equal to or less than 10 weft fibers per cm in the longitudinal extension, and
cross-linking (S12) the heat shrinkable weft fiber, **characterised in that** at least one warp fiber comprises a non-conductive polyamide core plated with a conductive metal layer and **in that** the non-conductive core of the warp fibers comprises nylon 66 or nylon 6.

14. Method according to claim 14, wherein the weft fibers are radiation cross-linked or peroxide cross-linked.

## Patentansprüche

1. Schlauch (10) aus Wärmeschrumpf-Gewebe zum Abschirmen eines länglichen Bauteils gegenüber elektromagnetischer Interferenz (EMI), wobei der Schlauch aus Wärmeschrumpf-Gewebe umfasst:
elektrisch leitende Kettfäden (100), wobei die Kettfäden zur Abschirmung des länglichen Bauteils gegenüber EMI dienen und sich die Kettfäden in einer Längsausdehnung des länglichen Bauteils erstrecken;
schrumpfbare Schussfäden (200), die sich quer zu den elektrisch leitenden Kettfäden erstrecken, wobei die Schussfäden zum Schrumpfen des Gewebeschlauchs in einer radialen Dimension senkrecht zu der Längsausdehnung dienen;
wobei die Schussfäden mit den Kettfäden verwoben sind und so den Gewebeschlauch bilden, mit dem das längliche Bauteil vor EMI geschützt wird, und
die Schussfäden vernetzt sind, um dem Schlauch ein Formgedächtnis zu verleihen, so dass der Gewebeschlauch nach Wärmeeinwirkung in Umfangsrichtung schrumpft,
wobei der Gewebeschlauch vor Schrumpfung 10 Kettfäden pro Zentimeter oder mehr und 50 Kettfäden oder weniger pro Zentimeter in einer Umfangsdimension senkrecht zu der radialen Abmessung sowie drei Schussfäden pro Zentimeter oder mehr und zehn Schussfäden oder weniger pro Zentimeter in der Längsausdehnung umfasst, **dadurch gekennzeichnet, dass** die Kettfäden einen nicht leitenden Polyamid-Kern umfassen, der mit einer Lage aus leitendem Metall beschichtet ist, und **dadurch, dass** der nicht leitende Kern der Kettfäden Nylon 66 oder Nylon 6 umfasst.

2. Schlauch aus Wärmeschrumpf-Gewebe nach Anspruch 1, wobei jeder Kettfaden als ein Multifilgarn ausgebildet ist, und jedes Einzelfilament des Multifilgarns mit der Lage aus leitendem Metall beschichtet ist.

3. Schlauch aus Wärmeschrumpf-Gewebe nach einem der Ansprüche 1 bis 2, wobei das Metall Silber, Kupfer, Nickel oder Zinn umfasst und das Metall vorzugsweise Silber mit einer Reinheit von 99,9 % oder mehr umfasst.

4. Schlauch aus Wärmeschrumpf-Gewebe nach einem der vorangehenden Ansprüche, wobei die Kettfäden einen spezifischen elektrischen Widerstand von 1 Milliohm Meter oder mehr und/oder einen längenbezogenen elektrischen Widerstand von 50 Ohm/Meter oder weniger haben.

5. Schlauch aus Wärmeschrumpf-Gewebe nach einem der vorangehenden Ansprüche, wobei die beschichteten Kettfäden eine Feinheit von 1.000 dtex oder mehr und 1.500 dtex oder weniger, vorzugsweise von 1.200 dtex oder mehr und 1.250 dtex oder weniger haben.

6. Schlauch aus Wärmeschrumpf-Gewebe nach einem der vorangehenden Ansprüche, wobei der nicht leitende Polyamid-Kern eine Feinheit von 200 dtex oder mehr und 300 dtex oder weniger hat, vorzugsweise der nicht leitende Polyamid-Kern eine Feinheit von 230 dtex oder mehr und 250 dtex oder weniger hat.

7. Schlauch aus Wärmeschrumpf-Gewebe nach einem der vorangehenden Ansprüche, wobei die beschichteten Kettfäden eine Verdrillung von 350 Drehungen pro Meter oder mehr und eine Verdrillung von 400 Drehungen pro Meter oder weniger hat, vorzugsweise die beschichteten Kettfäden mit einer Z-Drehung versponnen sind.

8. Schlauch aus Wärmeschrumpf-Gewebe nach einem der vorangehenden Ansprüche, wobei die vernetzbaren Schussfäden Polyolefin, Copolymere auf Basis von Polyolefin, Nylon oder/und Fluorpolymere umfassen.

9. Schlauch aus Wärmeschrumpf-Gewebe nach einem der vorangehenden Ansprüche, wobei die Länge vernetzter Schussfäden in einem gedehnten Zustand (12) vor Schrumpfung das 1,5-fache der Länge der Schussfäden nach Schrumpfung oder mehr beträgt und/oder wobei die Länge vernetzter Schussfäden in einem gedehnten Zustand (12) vor Schrumpfung das 4-fache der Länge der Schussfäden nach Schrumpfung oder weniger beträgt.

10. Schlauch aus Wärmeschrumpf-Gewebe nach einem der vorangehenden Ansprüche, wobei die elektrisch leitenden Kettfäden eine äußerste Schicht aus einem isolierendem Material umfasst, die vorzugsweise Nitrilkautschuk umfasst.

11. Schlauch aus Wärmeschrumpf-Gewebe nach einem der vorangehenden Ansprüche, wobei die beschichteten Kettfäden eine Reißfestigkeit von 35 cN/tex oder mehr und/oder eine Reißfestigkeit von 60 cN/tex oder weniger haben, vorzugsweise die beschichteten Kettfäden eine Reißfestigkeit von 40 cN/tex oder mehr und/oder eine Reißfestigkeit von 55 cN/tex oder weniger haben und/oder wobei die beschichteten Kettfäden eine Bruchdehnung von 10 % oder mehr und eine Bruchdehnung von 40 % oder weniger haben, vorzugsweise die beschichteten Kettfäden eine Bruchdehnung von 20 % oder mehr und eine Bruchdehnung von 32 % oder weniger haben.

12. Schlauch aus Wärmeschrumpf-Gewebe nach einem der vorangehenden Ansprüche, wobei der Gewebeschlauch eine Naht umfasst, die sich in der Längsausdehnung des länglichen Bauteils erstreckt, vorzugsweise der Gewebeschlauch nur eine Naht umfasst, die sich in der Längsausdehnung des länglichen Bauteils erstreckt, und optional ein Interlock-Garn in den Gewebeschlauch eingewebt ist und das Interlock-Garn die Naht bildet.

13. Verfahren zum Herstellen eines Schlauchs aus Wärmeschrumpf-Gewebe zum Abschirmen eines länglichen Bauteils gegenüber EMI, wobei das Verfahren umfasst:
Verweben (S10) elektrisch leitender Kettfäden (100) mit wärmeschrumpfbaren Schussfäden (200), wobei die Kettfäden zum Abschirmen des länglichen Bauteils gegenüber EMI dienen und sich die Kettfäden in einer Längsausdehnung des Gewebeschlauchs erstrecken und sich die Schussfäden quer zu den Kettfäden erstrecken und so den Schlauch aus Wärmeschrumpf-Gewebe bilden;
wobei der Gewebeschlauch vor Schrumpfung 10 Kettfäden pro Zentimeter oder mehr und 50 Kettfäden oder weniger pro Zentimeter in einer Umfangsdimension senkrecht zu der radialen Richtung und drei Schussfäden oder mehr pro Zentimeter und 10 Schussfäden oder weniger pro Zentimeter in der Längsausdehnung umfasst, sowie
Vernetzen (S12) der wärmeschrumpfbaren Schussfäden, **dadurch gekennzeichnet, dass** wenigstens ein Kettfaden einen nicht leitenden Polyamid-Kern umfasst, der mit einer Lage aus leitendem Metall beschichtet ist, und **dadurch, dass** der nicht leitende Kern der Kettfäden Nylon 66 oder Nylon 6 umfasst.

14. Verfahren nach Anspruch 13, wobei die Schussfäden mittels Strahlung vernetzt werden oder peroxidisch vernetzt werden.

## Revendications

1. Gaine en tissu thermorétractable (10) pour le blindage d'un composant allongé contre les interférences électromagnétiques, EMI, la gaine en tissu thermorétractable comprenant :
des fibres de chaîne conductrices d'électricité (100), les fibres de chaîne pour le blindage EMI du composant allongé, les fibres de chaîne s'étendant dans une extension longitudinale du composant allongé ;
des fibres de trame rétractables (200) s'étendant transversalement aux fibres de chaîne conductrices d'électricité, les fibres de trame permettant de rétracter le tube en tissu dans une dimension radiale perpendiculaire à l'extension longitudinale ;
dans laquelle les fibres de trame sont tissées avec les fibres de chaîne, formant ainsi le tube en tissu pour protéger le composant allongé contre les interférences électromagnétiques, et
les fibres de trame sont réticulées pour créer une mémoire dans le tube de sorte que le tube en tissu se rétracte circonférentiellement après application de chaleur, et
dans laquelle le tube en tissu comprend avant rétraction un nombre de fibres de chaîne égal ou supérieur à 10 par cm et égal ou inférieur à 50 par cm dans une dimension circonférentielle perpendiculaire à la dimension radiale, et un nombre de fibres de trame égal ou supérieur à 3 par cm et égal ou inférieur à 10 par cm dans l'extension longitudinale,
**caractérisée en ce que** les fibres de chaîne comprennent une âme non conductrice en polyamide plaquée d'une couche métallique conductrice et **en ce que** l'âme non conductrice des fibres de chaîne comprend du nylon 66 ou du nylon 6.

2. Gaine en tissu thermorétractable selon la revendication 1, dans laquelle chaque fibre de chaîne est formée comme un fil multifilament, chaque filament individuel du fil multifilament est plaqué avec une couche métallique conductrice.

3. Gaine en tissu thermorétractable selon l'une quelconque des revendications 1 à 2, dans laquelle le métal comprend de l'argent, du cuivre, du nickel ou de l'étain, de préférence le métal comprend de l'argent ayant une pureté égale ou supérieure à 99,9 %.

4. Gaine en tissu thermorétractable selon l'une quelconque des revendications précédentes, dans laquelle les fibres de chaîne ont une résistance électrique supérieure ou égale à 1 milli ohms*mètre et/ou une résistivité électrique inférieure ou égale à 50 ohms/mètre.

5. Gaine en tissu thermorétractable selon l'une quelconque des revendications précédentes, dans laquelle les fibres de chaîne plaquées ont une densité linéaire supérieure ou égale à 1 000 dtex, et inférieure ou égale à 1 500 dtex, de préférence supérieure ou égale à 1 200 dtex et inférieure ou égale à 1 250 dtex.

6. Gaine en tissu thermorétractable selon l'une quelconque des revendications précédentes, dans laquelle l'âme non conductrice en polyamide a une densité linéaire égale ou supérieure à 200 dtex et égale ou inférieure à 300 dtex, de préférence l'âme non conductrice en polyamide a une densité linéaire égale ou supérieure à 230 dtex et égale ou inférieure à 250 dtex.

7. Gaine en tissu thermorétractable selon l'une quelconque des revendications précédentes, dans laquelle les fibres de chaîne plaquées ont une torsion supérieure ou égale à 350 tours par mètre et une torsion inférieure ou égale à 400 tours par mètre, de préférence dans laquelle les fibres de chaîne plaquées sont filées avec une torsion en Z.

8. Gaine en tissu thermorétractable selon l'une quelconque des revendications précédentes, dans laquelle les fibres de trame réticulables comprennent au moins l'un parmi une polyoléfine, des copolymères à base de polyoléfine, des nylons et des fluoropolymères.

9. Gaine en tissu thermorétractable selon l'une quelconque des revendications précédentes, dans laquelle la longueur des fibres de trame réticulées à l'état expansé (12) avant rétraction est égale ou supérieure à 1,5 fois la longueur des fibres de trame après rétraction, et/ou dans laquelle la longueur des fibres de trame réticulées à l'état expansé (12) avant rétraction est égale ou inférieure à 4 fois la longueur des fibres de trame après rétraction.

10. Gaine en tissu thermorétractable selon l'une quelconque des revendications précédentes, dans laquelle les fibres de chaîne conductrices d'électricité comprennent une couche extérieure d'un matériau isolant, comprenant de préférence du caoutchouc nitrile.

11. Gaine en tissu thermorétractable selon l'une quelconque des revendications précédentes, dans laquelle les fibres de chaîne plaquées ont une ténacité égale ou supérieure à 35 cN/tex et/ou une ténacité égale ou inférieure à 60 cN/tex, de préférence les fibres de chaîne plaquées ont une ténacité égale ou supérieure à 40 cN/tex et/ou une ténacité égale ou inférieure à 55 cN/tex, et/ou dans lequel les fibres de chaîne plaquées ont un allongement jusqu'à la rupture égal ou supérieur à 10 % et un allongement jusqu'à la rupture égal ou inférieur à 40 %, de préférence les fibres de chaîne plaquées ont un allongement jusqu'à la rupture égal ou supérieur à 20 % et un allongement jusqu'à la rupture égal ou inférieur à 32 %.

12. Gaine en tissu thermorétractable selon l'une quelconque des revendications précédentes, dans laquelle la gaine textile comprend une couture s'étendant dans le prolongement longitudinal du composant allongé, de préférence la gaine textile comprend une seule couture s'étendant dans le prolongement longitudinal du composant allongé, éventuellement un fil d'emboîtement est tissé dans la gaine textile, le fil d'emboîtement formant la couture.

13. Procédé de construction d'une gaine en tissu thermorétractable pour le blindage d'un composant allongé contre les interférences électromagnétiques, le procédé comprenant :
le tissage (S10) de fibres de chaîne conductrices d'électricité (100), la fibre de chaîne pour le blindage EMI du composant allongé, avec des fibres de trame thermorétractables (200), dans lequel les fibres de chaîne s'étendant dans une extension longitudinale du tube en tissu et les fibres de trame s'étendant transversalement aux fibres de chaîne, formant ainsi le tube en tissu thermorétractable ;
dans lequel le tube en tissu comprend avant rétraction un nombre de fibres de chaîne égal ou supérieur à 10 par cm et égal ou inférieur à 50 par cm dans une dimension circonférentielle perpendiculaire à la dimension radiale, et un nombre de fibres de trame égal ou supérieur à 3 par cm et égal ou inférieur à 10 par cm dans l'extension longitudinale, et
réticulation (S12) de la fibre de trame thermorétractable, **caractérisée en ce qu'**au moins une fibre de chaîne comprend une âme non conductrice en polyamide plaquée d'une couche métallique conductrice et **en ce que** l'âme non conductrice des fibres de chaîne comprend du nylon 66 ou du nylon 6.

14. Procédé selon la revendication 14, dans lequel les fibres de trame sont réticulées par rayonnement ou par peroxyde.
